# EUROPEAN PATENT APPLICATION

(11) **EP 4 105 720 A1**
(43) Date of publication of application: **21.12.2022**
(21) Application number: 21179874.9
(22) Date of filing: 16.06.2021
(51) Int. Cl.: G03F 7/20, H01L 21/683

(54) **SUBSTRATE HOLDER AND METHOD**

(71) Applicant: ASML Netherlands B.V., 5500 AH Veldhoven (NL)
(72) Inventor: VAN DE KERKHOF, Marcus Adrianus, 5500 AH Veldhoven (NL)
(74) Representative: Pei, Fei

(57) **Abstract**

A substrate holder for holding a substrate, comprising a frame, a surface clamping device arranged on the frame configured to electrostatically attract the substrate at an upper surface thereof, and a fluid flow device arranged on the frame configured to apply a repulsive force to the substrate. The substrate holder can be used to contactlessly hold and deform the substrate and thereby control a shape of the substrate. The substrate holder is suitable for use in a semiconductor processing apparatus and can operate in a vacuum or near-vacuum environment, such as in an EUV lithographic apparatus.

## Description

### FIELD

The present invention relates to a substrate holder and method. The substrate holder and method are compatible with vacuum or near-vacuum environments, such as those present in an EUV lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features that can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In a lithographic apparatus, one or more substrate holders are used to handle substrates, for example to load and unload a substrate on and from a substrate support on which the substrate is supported during the lithographic process.

A known substrate holder comprises a gripper configured to contact and thereby support the substrate from an underside of the substrate. To load the substrate on the substrate support, the substrate support is provided with loading pins that are movable in a vertical direction out of a support surface of the substrate support. The known substrate holder comprises an actuation system that can arrange the gripper in a position to load the substrate on the extended loading pins. Subsequently, the loading pins can be lowered to place the substrate on the support surface of the substrate support. The support surface of the substrate support may comprise burls on which the substrate is supported. Electrostatic clamps are used to hold the substrate in a fixed position on the substrate support. The electrostatic clamps are activated to clamp the substrate against the burls.

Loading a substrate on the substrate support may be a challenging task in case the substrate has a substantial deformation. Ideally, a substrate is completely flat or slightly bowl-shaped. This allows a low-stress loading of the substrate on the substrate support with a minimum of slip of the substrate over the support surface of the substrate support. In practice, the substrate may show considerable deformation. The substrate may for example have an umbrella shape, a bowl shape, a saddle shape, or other shapes. Upon activation of the electrostatic clamps, the substrate may be forced into a shape that conforms to a plane of the support surface burls, and may undergo some frictional slip across the burls. Loading a deformed substrate on the substrate support may lead to internal stresses in the loaded substrate and/or substantial slip over the support surface, for example over the burls of the support surface. The internal stress in the substrate may lead to overlay errors and/or focus errors. Slipping of the substrate over the support surface may lead to wear of the support surface of the substrate support, in particular the burls thereof. Repeated wear of the support surface may require repair and/or replacement of the substrate support. The wear of the support surface of the substrate support may lead to support surface flatness drift and/or substrate load grid drift due to differences in roughness of the burls. This in turn may lead to lithographic errors such as overlay errors and/or focus errors.

### SUMMARY

It is an object of the invention to provide a substrate holder that improves the loading of substrates on the support surface of a substrate support.

According to a first aspect of the present disclosure there is provided a substrate holder for holding a substrate, comprising a frame, a surface clamping device arranged on the frame configured to electrostatically attract the substrate at an upper surface thereof, and a fluid flow device arranged on the frame configured to apply a repulsive force to the substrate.

The substrate holder is advantageously suitable for use in vacuum or near-vacuum environments, such as within an EUV lithographic apparatus or a chemical vapor deposition apparatus.

Known substrate holders use a platform to contact and hold the substrate at an underside of the substrate. When loading and unloading the substrate to and from different modules, the platform must be introduced and removed, which requires time. The substrate holder of the present invention advantageously avoids the need for a platform. The substrate holder advantageously provides significantly faster loading and unloading of a substrate compared to known substrate holders (e.g. about three times faster than prior art substrate holders that use a platform). In manufacturing operations (particularly high-volume manufacturing operations), the time saved by the substrate holder of the present invention enables a greater throughput of substrates and/or allows more time to perform ancillary processes such as measurements of the substrate. For example, when loading and unloading the substrate from a measurement module in a lithographic apparatus, a greater number of alignment points on the substrate may be measured which enables a more accurate alignment measurement. This in turn provides improved overlay measurement and correction capabilities.

The surface clamping device is configured to be positioned above the substrate. As such, the substrate holder may be referred to as a top loader because the surface clamping device engages the upper surface of the substrate from above the substrate.

The fluid flow device may be configured to be positioned above the substrate. The fluid flow device may be configured to apply the repulsive force to the upper surface of the substrate.

The upper surface of the substrate may correspond to a surface of the substrate that has undergone and/or will undergo one or more manufacturing processes. The one or more manufacturing processes may comprise, for example, an application of a thin film or layer such as a photoresist to the upper surface, exposing the upper surface to radiation or electrons during a lithographic process, an etching process, etc. The upper surface of the substrate may be referred to as a process surface of the substrate. The process surface of the substrate may oppose a base of the substrate.

The electrostatic attraction and the repulsive force may be substantially antiparallel. The electrostatic attraction and the repulsive force may act along a substantially vertical direction.

The substrate may be a semiconductor substrate. The substrate may be a semiconductor wafer. The substrate may comprise a silicon wafer.

The surface clamping device and the fluid flow device may be configured to cooperate to provide contactless manipulation of the substrate.

Contactless manipulation of the substrate advantageously allows manipulation of contact-sensitive surfaces or portions of the substrate. For example, a substrate comprising a layer of photoresist may be manipulated without negatively affecting the contact-sensitive photoresist.

The contactless manipulation may comprise holding and/or moving and/or deforming the substrate in a controlled manner.

The surface clamping device may comprise a plurality of electrostatic clamps configured to electrostatically attract the upper surface of the substrate.

The plurality of electrostatic clamps advantageously provides fine control of the manipulation of the substrate. For example, different electrostatic clamps may act on different areas of the upper surface of the substrate, thereby allowing individual control of the attractive forces acting on different areas of the substrate.

The fluid flow device may comprise a plurality of conduits configured to convey a flow of fluid that applies the repulsive force to the substrate.

The plurality of conduits advantageously provide fine control of the manipulation of the substrate. For example, different conduits may provide one or more fluid flows that act on different areas of the substrate, thereby allowing individual control of the repulsive forces acting on different areas of the substrate.

The flow of fluid may apply a pressure to the substrate. The pressure may be an overpressure.

The fluid may comprise a gas. The gas may comprise air.

A rate of the flow of fluid may be substantially constant. The flow of fluid may be referred to as a static air bearing.

The plurality of electrostatic clamps and the plurality of conduits may cooperate to form a plurality of contactless clamping devices.

The contactless clamping devices advantageously provide fine control of the manipulation of the substrate by allowing individual control of the attractive forces and the repulsive forces acting on different areas of the substrate.

An arrangement of the contactless clamping devices on the frame may correspond to a shape of the substrate. For example, a circular arrangement of contactless clamping devices may be used to manipulate a circular substrate.

The contactless clamping devices may be arranged in a concentric circle pattern.

At least one of the plurality of electrostatic clamps may comprise an aperture. At least one of the plurality of conduits may be configured to provide a flow of a fluid through the aperture.

The aperture-conduit combination advantageously provides a compact system for manipulating the substrate.

The electrostatic clamp may be ring-shaped. An aperture at a center of the ring-shaped electrostatic clamp may act as the conduit for the flow of fluid.

The substrate holder may comprise an actuation system configured to move the surface clamping device and the fluid flow device with respect to each other.

The actuation system advantageously provides greater control of a deformation applied to the substrate by the substrate holder.

The actuation system may be configured to move the contactless clamping devices with respect to each other. The contactless clamping devices may be movable at least in a first direction substantially perpendicular to an upper surface of a substrate held by the contactless clamping devices.

The substrate holder may comprise a controller configured to adjust at least one of the electrostatic attraction and the repulsive force to deform the substrate into a predetermined shape.

The controller advantageously causes the substrate to be deformed (e.g. bent) into a desired shape (e.g. a substantially flat upper surface). For example, the controller may be configured to correct a warped shape of the upper surface of the substrate.

The controller may be configured to substantially flatten the upper surface of the substrate.

The controller may be configured to activate one or more of the contactless clamping devices to clamp the upper surface of the substrate.

The controller may be configured to control the positions of the contactless clamping devices to deform the substrate.

The surface clamping device may be configured to detect a position and/or a shape of the substrate.

The controller may be configured to use information detected by the surface clamping device to adjust at least one of the electrostatic attraction and the repulsive force to control a position and/or a shape of the substrate.

The controller may be configured to use the substrate position information to prevent a collision between the substrate holder and the substrate.

The flow of fluid may be configured to control a temperature of the surface clamping device.

The flow of fluid may be configured to control a temperature of the substrate.

The substrate holder may comprise an edge gripper system configured to hold the substrate at an edge thereof.

The edge gripper system may be configured to prevent sideways movement of the substrate.

According to a second aspect of the present disclosure there is provided a substrate manipulation system comprising the substrate holder of the first aspect and a substrate clamp comprising a support plane configured to support the substrate. The substrate holder is configured to apply the electrostatic attraction and the repulsive force such that the upper surface of the substrate substantially matches the support plane.

Deforming the substrate such that the upper surface of the substrate substantially matches the support plane advantageously reduces overlay errors (e.g. on-product-overlay is improved by more than 1 nm) when the substrate manipulation system is used in a lithographic apparatus.

Deforming the substrate such that the upper surface of the substrate substantially matches the support plane advantageously reduces frictional movement of the substrate when the substrate is clamped by the substrate clamp. This in turn advantageously reduces wear on the substrate clamp thereby increasing an operational lifetime of the substrate clamp compared to known substrate manipulation systems.

The support plane may comprise a plurality of burls.

A measured shape of the substrate held or to be held by the substrate clamp may be used as an input for the controller to control at least one of the electrostatic attraction and the repulsive force.

The controller may be configured to control positions of the contactless clamping devices with respect to each other.

The controller may be configured to control positions of the contactless clamping devices to adapt a shape of the substrate held by the contactless clamping devices.

A measured shape of the substrate held or to be held by the substrate clamp may be used as an input for the controller to control the positions of the contactless clamping devices to adapt a shape of the substrate held by the contactless clamping devices.

According to a third aspect of the present disclosure there is provided a substrate manipulation system comprising the substrate holder of the first aspect and a substrate pre-clamp configured to deform the substrate into a deformed shape. The substrate holder is configured to apply the electrostatic attraction and the repulsive force to maintain the deformed shape of the substrate.

Maintaining a pre-deformed shape of the substrate advantageously reduces overlay errors (e.g. on-product-overlay is improved by more than 1 nm) when the substrate manipulation system is used in a lithographic apparatus.

Maintaining a pre-deformed shape of the substrate advantageously reduces frictional movement of the substrate when the substrate is manipulated by the substrate manipulation system. This in turn advantageously reduces wear on the substrate manipulation system thereby increasing an operational lifetime of the substrate manipulation system compared to known substrate manipulation systems.

According to a fourth aspect of the present disclosure there is provided a semiconductor processing apparatus comprising the substrate holder of the first aspect. The substrate holder is arranged to operate in a vacuum or near-vacuum environment.

The vacuum or near-vacuum environment may comprise a pressure of about 10 Torr or less. The vacuum or near-vacuum environment may comprise a pressure of about 1 Torr or less.

The semiconductor processing apparatus may be a lithographic apparatus configured to expose the substrate to patterned radiation.

The lithographic apparatus may be an EUV lithographic apparatus. The lithographic apparatus may be an electron beam lithographic apparatus.

The semiconductor processing apparatus may be a chemical vapor deposition apparatus configured to deposit material on the substrate.

According to a fifth aspect of the present disclosure there is provided a method of holding a substrate comprising electrostatically attracting an upper surface of the substrate and using a flow of fluid to apply a repulsive force to the substrate.

The method may comprise using cooperation between the electrostatic attraction and the repulsive force to contactlessly manipulate the substrate.

The method may comprise adjusting at least one of the electrostatic attraction and the repulsive force to deform the substrate into a predetermined shape.

The method may comprise using a substrate pre-clamp to deform the substrate such that the upper surface of the substrate substantially matches a support plane of the substrate pre-clamp. The method may comprise applying the electrostatic attraction and the repulsive force to maintain the deformed shape of the substrate.

The method may comprise using the fluid flow to control a temperature of the substrate.

According to a sixth aspect of the present disclosure there is provided a method of projecting a patterned beam of radiation onto a substrate comprising the method of the fifth aspect.

According to a seventh aspect of the present disclosure there is provided a method of depositing material on a substrate comprising the method of the fifth aspect.

According to a seventh aspect of the present disclosure there is provided a computer program comprising computer readable instructions configured to cause a computer to carry out a method according to the fifth aspect.

According to an eighth aspect of the present disclosure there is provided a computer readable medium carrying a computer program according to the seventh aspect.

According to a ninth aspect of the present disclosure there is provided a computer apparatus comprising a memory storing processor readable instructions, and a processor arranged to read and execute instructions stored in said memory. Said processor readable instructions comprise instructions arranged to control the computer to carry out a method according to the fifth aspect.

### BRIEF DESCRIPTION OF THE DRAWINGS

Embodiments of the invention will now be described, by way of example only, with reference to the accompanying schematic drawings, in which:
- Fig. 1 schematically depicts a lithographic system comprising a radiation source, a lithographic apparatus and a substrate holder in accordance with the present disclosure.
- Fig. 2 schematically depicts a side view of a substrate holder comprising a surface clamping device and a fluid flow device according to an aspect of the present disclosure.
- Fig. 3 schematically depicts the substrate holder of Fig. 2 after the surface clamping device and the fluid flow device have cooperated to provide contactless manipulation of the substrate W.
- Fig. 3A schematically depicts a magnified view of a part of Fig. 3 showing a contactless clamping device in more detail.
- Fig. 4 schematically depicts a view from underneath the substrate holder of Fig. 2 showing a configuration of the contactless clamping devices.
- Fig. 5 schematically depicts a perspective view from above a substrate holder comprising an edge gripper system according to an embodiment of the present disclosure.
- Fig. 6 schematically depicts a substrate manipulation system comprising a substrate clamp according to an embodiment of the present disclosure.
- Fig. 7 schematically depicts a substrate manipulation system comprising a substrate pre-clamp according to an embodiment of the present disclosure.
- Fig. 8 shows a flowchart of a method of holding a substrate according to an embodiment of the present disclosure.

### DETAILED DESCRIPTION

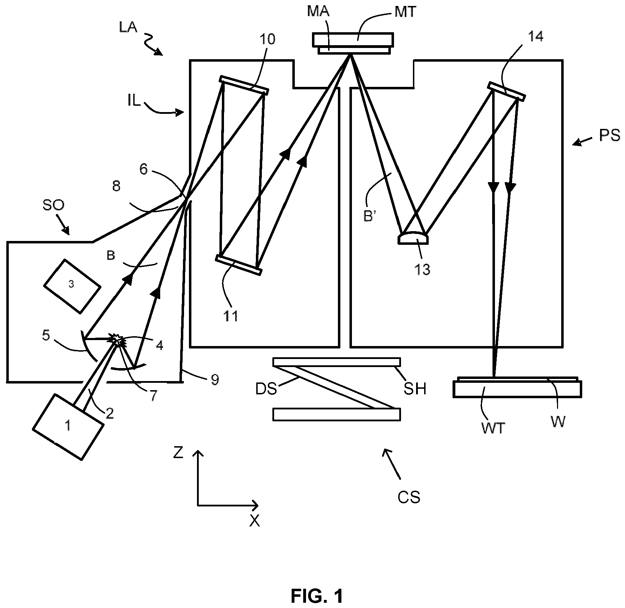

Fig. 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of four or eight may be applied. Although the projection system PS is illustrated as having only two mirrors 13, 14 in Fig. 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. Hydrogen) at a pressure well below atmospheric pressure (e.g. less than about 10 Torr, such as 1 Torr or less), may be provided in the radiation source SO, in the illumination system IL, and/or in the projection system PS.

The radiation source SO shown in Fig. 1 is, for example, of a type that may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure that is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Fig. 1 depicts the radiation source SO as a laser produced plasma (LPP) source, any suitable source such as a discharge produced plasma (DPP) source or a free electron laser (FEL) may be used to generate EUV radiation.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention.

In the lithographic apparatus LA of Fig. 1, a carrier system CS is provided. The carrier system CS is configured to manipulate (e.g. hold, move, deform and release) a substrate W. The carrier system CS comprises a substrate holder SH and a displacement system DS, for example a robotic system such as a robotic arm or a linear movement system. In the example of Fig. 1, the carrier system CS is configured to move the substrate W between the substrate table WT and another location, for example a substrate storage (not shown). The carrier system CS may additionally or alternatively be used to hold a substrate W in other devices related to the processing of substrates in the lithographic process, in which handling of the substrate W with high accuracy is desired. The carrier system CS may be used in semiconductor processing apparatus other the lithographic apparatus such as, for example, a chemical vapor deposition apparatus.

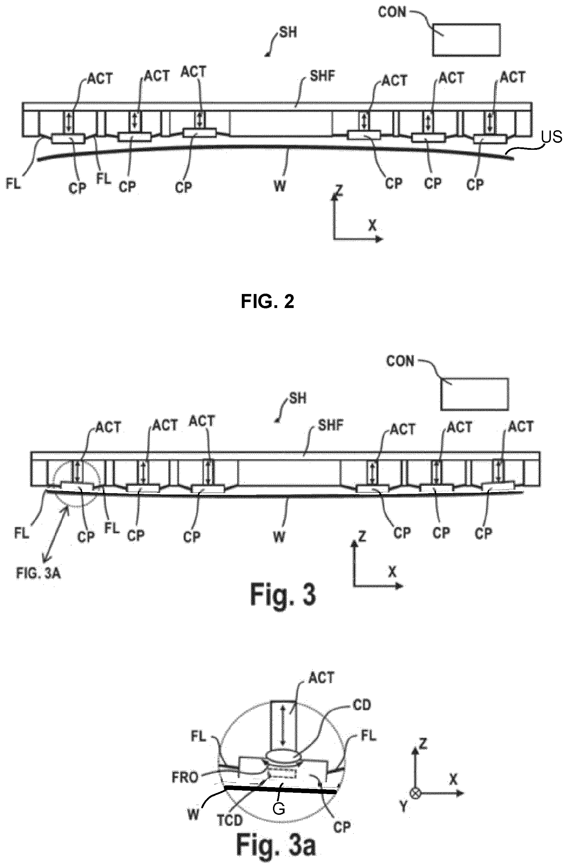

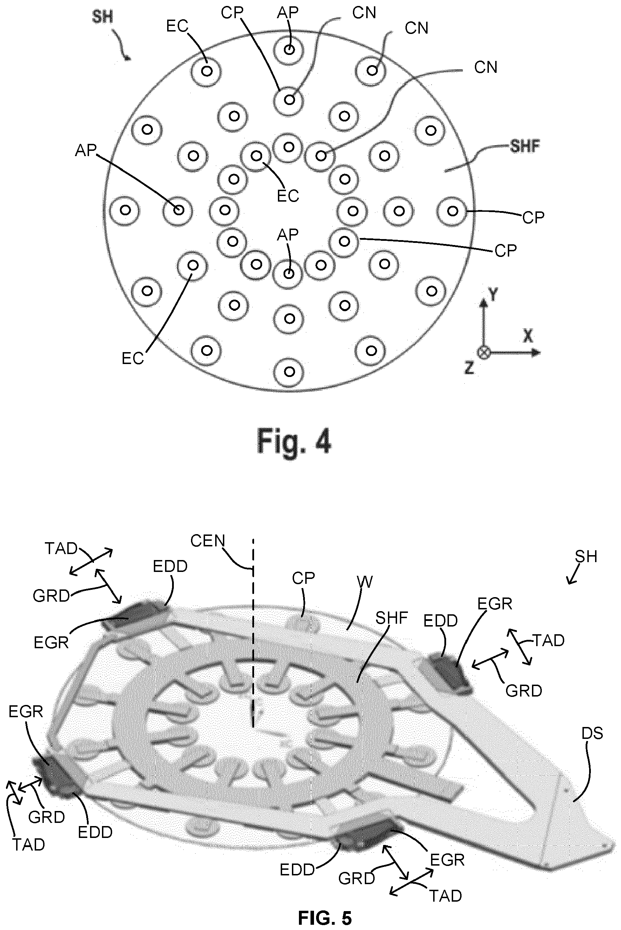

Fig. 2 schematically depicts a side view of a substrate holder SH configured to hold a substrate W, the substrate holder SH comprising a surface clamping device and a fluid flow device according to an aspect of the present disclosure. The substrate holder SH comprises a frame SHF. The substrate holder SH further comprises a surface clamping device arranged on the frame SHF. The surface clamping device is configured to electrostatically attract the substrate W at an upper surface US thereof. In the example of Fig. 2, each surface clamping device comprises an electrostatic clamp (shown in Fig. 4) configured to electrostatically attract the upper surface US of the substrate W. The electrostatic clamps may comprise, for example, a dielectric layer positioned over a conductive electrode. The electrostatic attraction pulls the substrate W towards the substrate holder SH (i.e. acts in the positive z-direction). The substrate holder SH further comprises a fluid flow device (shown in Fig. 4) arranged on the frame SHF. The fluid flow device is configured to apply a repulsive force to the substrate W. In the example of Fig. 2, the fluid flow device comprises a plurality of conduits (shown in Fig. 4) that pass through the surface clamping devices. The repulsive force pushes the substrate W away from the substrate holder SH (i.e. acts in the negative z-direction). The electrostatic attraction and the repulsive force may therefore be substantially antiparallel. In the example of Fig. 2, the plurality of electrostatic clamps and the plurality of conduits cooperate to form a plurality of contactless clamping devices CP configured to contactlessly hold and manipulate (e.g. deform) the substrate W.

During semiconductor processing (e.g. lithographic processing, chemical vapor deposition, ion implantation, etc.) of the substrate W (e.g. a semiconductor wafer such as a silicon wafer), a clamping voltage may be applied between the substrate W and the electrostatic clamps to generate an attractive electrostatic force that pulls the upper surface US of the substrate W toward the substrate holder SH. The fluid flow device provides a flow of fluid such as, for example, Hydrogen gas or air that generates a repulsive force that pushes the upper surface US of the substrate W away from the substrate holder SH. The flow of fluid used for the contactless clamping devices CP may be supplied or discharged through a number of passageways that may be provided on or in the substrate holder frame SHF. For example, the substrate holder frame SHF may comprise a hollow frame having internal channels that can be used to transport a flow of fluid such as air or another medium.

The strengths of the electrostatic attraction and the repulsive force may depend upon the weight of the substrate W (e.g. the force required to hold the substrate W in place against the force of gravity) and the extent to which the substrate W is warped (e.g. the forces required to deform the substrate W into a desired shape). For example, the substrate W may be warped such that a difference of about 1 mm or less exists between a z-position of a center of the substrate W and a z-position of an edge of the substrate W. In this example, the strengths of the electrostatic attraction and the repulsive force may be selected to reduce the difference of about 1 mm or less to a difference of about 0 mm (i.e. to make the substrate W substantially flat). The substrate W may have a weight of about 100 g or more. The substrate W may have a weight of about 400g or less. In the example of a substrate W that is to undergo a lithographic exposure (such as the substrate W shown in Fig. 1), the substrate W may have a weight of between about 100g and about 200g, e.g. about 115g. In the example of a reticle that is configured pattern a beam of radiation (such as the reticle MA shown in Fig. 1), the substrate W (i.e. the reticle in this example) may have a weight of between about 150g and about 400g, e.g. about 350g. The forces required to deform the substrate may be about 0.2 N or more. The forces required to deform the substrate may be about 2 N or less.

The substrate holder SH may divide the total forces required to hold and deform the substrate W amongst the number of contactless clamping devices CP available. For example, if the substrate holder SH comprised 25 contactless clamping devices CP, the substrate W weighed about 100g and a deformation of about 1mm is needed to substantially flatten the substrate W, each contactless clamping device CP may be configured to apply a force of about 1 N to the substrate W. As another example, if the substrate holder SH comprised 15 contactless clamping devices CP, the substrate W weighed about 100g and a deformation of about 1mm is needed to substantially flatten the substrate W, each contactless clamping device CP may be configured to apply a force of between about 0.5 N and about 1 N to the substrate W. To generate the electrostatic attractive force, a voltage may be applied to the electrostatic clamps. For example, the voltage applied to the electrostatic clamps to generate the electrostatic attraction may be about 0.1 kV or more. The voltage applied to the electrostatic clamps to generate the electrostatic attraction may be about 2 kV or less.

The contactless clamping devices CP may be mounted on the substrate holder frame SHF through an actuation system comprising a plurality of actuators ACT that allow the contactless clamping devices CP to be moved individually in the z-direction with respect to the substrate holder frame SHF. The actuators ACT may comprise, for example, piezoelectric actuators. Other types of actuators may also be used. Advantageously, the actuators are position actuators that allow a high accuracy of position control of the contactless clamping devices CP. Flexures FL may be provided between the contactless clamping devices CP and the substrate holder frame SHF to guide movement of the contactless clamping devices CP with respect to the substrate holder frame SHF in the z-direction. The range of movement of the contactless clamping devices CP in the z-direction may be, for example, in the range of +/- about 1 mm. The range of movement of the contactless clamping devices CP in the z-direction may be, for example, in the range of +/- about 0.3 mm. One or more cooling devices (not shown) may be provided to compensate a heat load that may be caused by the actuators ACT.

The substrate holder SH comprises a controller CON. The controller CON may be configured to activate one or more of the contactless clamping devices CP to contactlessly clamp the upper surface US of the substrate W. The controller CON may be configured to deactivate one or more of the contactless clamping devices CP to contactlessly release the upper surface US of the substrate W. The controller CON may be configured to adjust at least one of the electrostatic attraction generated by the surface clamping device and the repulsive force generated by the fluid flow device to contactlessly deform the substrate W. For example, the controller CON may be configured to adjust a voltage applied to one or more of the electrostatic clamps and thereby control a strength of electrostatic attraction applied to the substrate W by the one or more electrostatic clamps. The controller CON may be configured to apply different voltages to different electrostatic clamps to provide electrostatic attraction that varies in strength across the upper surface US of the substrate W. As another example, the controller CON may be configured to adjust a flow rate of fluid passing through one or more conduits and thereby control a strength of the repulsive force applied to the substrate W by the fluid flow device. The flow rate of fluid passing through the one or more conduits may be about 10 NL/min or more. The flow rate of fluid passing through the one or more conduits may be about 50 NL/min or less. The pressure applied to the substrate W by the flow of fluid may be about 3 bar or more. The pressure applied to the substrate W by the flow of fluid may be about 7 bar or less. The controller CON advantageously allows the substrate W to be deformed (e.g. bent) into a desired shape. For example, the controller CON may be configured to correct a warped shape of the upper surface US of the substrate W by, for example, substantially flattening the upper surface US of the substrate W. The substrate W may be warped due to the effects of previous manufacturing processes such as, for example, annealing, baking, the application of one or more coatings (e.g. photoresist), etc.

The controller CON may be configured to control the positions of the contactless clamping devices CP to deform the substrate W. By controlling the individual positions in z-direction of the contactless clamping devices CP with respect to each other, the shape of the substrate W may be influenced and thereby controlled. The controller CON may be configured to provide control signals to the piezo actuators ACT to position the contactless clamping devices CP in the desired position with respect to each other. In the example of Fig. 2, the positions of the piezo actuators ACT are selected to contactlessly hold a warped substrate W having an umbrella shape. These positions may for example be based on a shape measurement of the substrate W before the substrate W is loaded on the substrate holder SH. This shape measurement can be done in stress-free state of the substrate W and fed as a feedforward signal to the controller CON to adapt the positions of the contactless clamping devices CP to the shape of the substrate W before it is held by the contactless clamping devices CP. When the substrate W is held by the substrate holder SH, the shape of the substrate W may be measured or determined in order to determine movements of the contactless clamping devices CP with respect to each other to apply a desired deformation to the substrate W. For example, the piezo actuators ACT may be used to obtain feedback on the actual position of the contactless clamping devices CP and therewith the actual shape of the substrate W held by the contactless clamping devices CP. Alternatively or additionally, other types of shape sensors may be provided with which the shape of the substrate W can be determined. A feedback signal of the actuator ACT force may be used, since a stiffness of the substrate W may be known. The umbrella shape of the substrate W is undesirable for loading the substrate W on a support surface (such as the substrate table WT of Fig. 1) as this may lead to lithographic errors (e.g. overlay errors, focus errors, etc.) and/or wear of the support surface (e.g. burls). The controller CON may communicate with and thereby control components of the substrate holder SH wirelessly or by a connector such as a cable (not shown).

The surface clamping device may be configured to detect a position and/or a shape of the substrate W. For example, the surface clamping device CP may act as a capacitance sensing system and may be configured to detect a capacitance between the electrostatic clamps and the substrate W. The capacitance between the electrostatic clamps and the substrate W may be proportional to a distance between the electrostatic clamps and the substrate W. The controller CON may be configured to use capacitance information detected by the surface clamping device to adjust at least one of the electrostatic attraction and the repulsive force to control a position and/or a shape of the substrate W. The controller CON may be configured to use the substrate position information to prevent a collision between the substrate holder SH and the substrate W. For example, if the surface clamping device detects the substrate W getting too close (e.g. about 50 µm or less) to the substrate holder SH the controller CON may decrease the electrostatic attraction and/or increase the repulsive force of the fluid flow device to prevent the substrate W from colliding with the substrate holder SH. The controller CON may be configured to use the substrate position information of each contactless clamping CP to determine and/or adjust a shape of the substrate W. An example of an adjustment of the shape of the substrate W can be seen on comparison between Fig. 2 (in which the substrate W has an umbrella shape) and Fig. 3 (in which the controller CON has adjusted the electrostatic attraction and/or the repulsive force to bend the substrate W into a bowl shape).

Fig. 3 schematically depicts the substrate holder SH of Fig. 2 after the surface clamping device and the fluid flow device have cooperated to provide contactless manipulation of the substrate W. Fig. 3 shows that adapting the positions of the contactless clamping devices CP with respect to each other may be used to adapt the shape of the upper surface US of the substrate W to a more desirable shape such as a substantially flat shape or a slightly bowl shape as depicted in Fig. 3. When the substrate W is held by the contactless clamping devices CP, the controller CON may control the piezo actuators ACT to move the contactless clamping devices CP to the desired position to obtain the bowl shape. An advantage of piezo actuators ACT is that the position of the contactless clamping devices CP can be accurately controlled by the actuation signals of the controller CON. In the example of Fig. 3, inner contactless clamping devices CP (with respect to a center of the substrate W) push the substrate W downwards (i.e. the negative z-direction) while outer contactless clamping devices CP pull the substrate W upwards (i.e. the positive z-direction) to obtain the desired shape. The surface clamping device and the fluid flow device are configured to cooperate to provide contactless manipulation of the substrate W. The contactless manipulation may comprise holding and/or moving and/or deforming the substrate W. A small gap (e.g. about 100 µm or less) exists between the contactless clamping device CP and the substrate W. The gap G is more visible in the magnified image of Fig. 3A.

Fig. 3A schematically depicts a magnified view of a part of Fig. 3 showing a contactless clamping device CP in more detail. It can be seen that there is provided a connection device CD that allows free rotation of the surface clamping pad CP with respect to the horizontal axes Rx, Ry over a limited angle of rotation, for example up to 50 mrad on the upper surface of the substrate W. The free rotation about Ry is indicated in FIG. 3A by an arrow FRO. This free rotation facilitates each of the contactless clamping devices CP to adapt its rotational position to the upper surface US of the substrate W. For example, each contactless clamping device CP may adapt its rotational position when it is placed during clamping of the substrate W on the upper surface US of the substrate W or when the shape of the substrate W is actively changed by adapting the relative positions of the contactless clamping devices CP in z-direction. Each of the contactless clamping devices CP may be provided with a connection device CD that may allow free rotation of the contactless clamping devices CP about one or more horizontal axes.

In Fig. 3A, a temperature control device TCD is shown in the contactless clamping device CP. Each of the contactless clamping devices CP may be provided with a temperature control device TCD, for example a heating element, to control its temperature individually. This temperature control may be desirable to correct for the cooling caused by expansion of the fluid (e.g. air) used by the fluid flow device. Each individual contactless clamping device CP may be provided with an individual temperature control device TCD or one temperature control device TCD may be provided for a group of contactless clamping devices CP. Alternatively or additionally, the flow of fluid provided through the conduits of the contactless clamping devices CP may be used to control a temperature of the surface clamping device and/or the substrate W. For example, the temperature control device TCD may be configured to control a temperature of the flow of fluid. The flow of fluid may then heat or cool the electrostatic clamps of the contactless clamping devices CP and/or the substrate W as desired. As another alternative or addition, an electric current may be provided to the electrostatic clamps of the contactless clamping devices CP. The current may be increased to heat the electrostatic clamps or decreased to cool the electrostatic clamps, thereby controlling a temperature of the surface clamping device. Heat from the electrostatic clamps may be transported to the substrate W by the flow of fluid, thereby also allowing control of the temperature of the substrate W. Unwanted changes in the temperature of the surface clamping device and/or the substrate W may cause the substrate W to undergo unwanted thermal deformations, which may in turn lead to manufacturing errors such as overlay, focus and/or alignment errors. Control of the temperature of the surface clamping device and/or the substrate W advantageously reduces or avoids such unwanted thermal deformations.

Fig. 4 schematically depicts a view from underneath the substrate holder SH of Fig. 2 showing a configuration of the contactless clamping devices CP. The fluid flow device comprises a plurality of conduits CN configured to convey a flow of fluid (e.g. air) that applies the repulsive force to the substrate. In the example of Fig. 4, each electrostatic clamp EC is ring-shaped and comprises an aperture AP at its center. Each conduit CN is configured to provide a flow of a fluid through the aperture AP of its respective electrostatic clamp EC.

The plurality of conduits CN advantageously provide fine control of the manipulation of the substrate. For example, different conduits CN may provide one or more fluid flows that act on different areas of the substrate, thereby allowing individual control of the repulsive forces acting on different areas of the substrate. The flow of fluid may apply a pressure to the substrate, which may described as being an overpressure when the substrate holder SH operates in vacuum or near-vacuum environments. A vacuum or near-vacuum environment may comprise pressures of about 10 Torr or less. A vacuum or near-vacuum environment may comprise pressures of about 1 Torr or less. A rate of the flow of fluid may be substantially constant such that the flow of fluid may be referred to as a static air bearing.

In the example of Fig. 4, the contactless clamping devices CP are arranged in three concentric circles, whereby in a radial direction each contactless clamping device CP of one circle is aligned with one of each of the other two circles. In alternative configurations, various amounts of contactless clamping devices CP with different mutual positions can be used. To optimize substrate W shaping a large number (e.g. 25 or more) of contactless clamping devices CP may be beneficial. The number of contactless clamping devices CP used may be balanced against the desired flow capacity per contactless clamping device CP, for example about 20 NL/min per contactless clamping device CP and associated equipment. The total mass of the contactless clamping devices CP may also be taken into account. Advantageously, there may be a minimum of contactless clamping devices CP in a radial direction (from the substrate W center axis outwards) to be able to apply a moment on the substrate W by two opposite forces in the z-direction provided by the two contactless clamping devices CP and associated piezo actuators ACT. As such, a first order wafer shape may be compensated, such as a bowl, umbrella, saddle and/or half-pipe shape. Three contactless clamping devices CP, as shown in the embodiment of Figs. 2-4, or more contactless clamping devices CP can be provided in radial direction to allow compensation of second or higher order shape deformations. More generally, more contactless clamping devices CP can be used to have more possibilities for adapting the shape of the substrate W held by the substrate holder SH. The mutual positions between the contactless clamping devices CP, such as rings, rows, etc. can be selected to optimize the shaping capabilities for specific shapes of deformed substrates W. In an embodiment, one or more of the contactless clamping devices CP may be retracted by the associated actuator ACT to a retracted position in which the respective contactless clamping devices CP will not be able to apply a force to the substrate W held by the substrate holder SH, for example by other non-retracted contactless clamping devices CP.

In the example of Figs. 2 and 3, each of the contactless clamping devices CP may be individually moved by its own associated piezo actuator ACT. In other embodiments, it is possible that two or more contactless clamping devices CP are associated with one piezo actuator. For example, each ring of contactless clamping devices CP may be subdivided in a number of ring segments comprising two or more contactless clamping devices CP. Each ring segment comprising two or more contactless clamping devices CP may be associated with one piezo actuator to move the respective ring segment to a desired position. For example, each of the three rings of the configuration shown in Fig. 4 may be subdivided in four ring segments, each ring segment comprising three contactless clamping devices CP. For each of these ring segments a respective actuator ACT may be provided to move the ring segment to a desired position in z-direction.

Fig. 5 schematically depicts a perspective view from above a substrate holder SH comprising an edge gripper system EGR according to an embodiment of the present disclosure. The substrate holder SH comprises a substrate holder frame SHF and four edge grippers EGR mounted on the substrate holder frame SHF. The four edge grippers EGR are configured to hold a substrate W at a circumferential edge thereof, in a substrate holding position. The substrate holding position is a location defined by the substrate holder SH in which a substrate W held by the substrate holder SH is ideally positioned, i.e. the substrate holder SH is designed to hold a substrate W in the substrate holding position. The four edge grippers EGR are equally distributed around the circumference of the substrate holding position. In other embodiments, another number of edge grippers EGR may be provided. One or more of the edge grippers EGR are actively position controlled in the radial direction. Not all these edge grippers EGR have to be actively position controlled in the radial direction. For example, one or more passive, mechanically pre-loaded edge grippers EGR may be combined with two or more actively position controlled edge grippers EGR. The edge grippers EGR may be distributed over the circumference of the substrate W in any suitable configuration. The edge grippers EGR comprise edge fingers (not shown) that are individually movable with respect to the substrate holder frame SHF in a gripping direction GRD. The gripping direction GRD extends in radial direction with respect to a center axis CEN of the substrate holding position. Each edge finger is associated with an edge gripper actuator (not shown) to move the edge finger in the gripping direction GRD towards or away from the edge of the substrate W.

The edge fingers can be used to hold the substrate W by pushing a gripping surface of the edge fingers against the circumferential edge of the substrate W. The gripping surface of the edge fingers act as a friction surface to hold the substrate W mainly by friction fit. The friction surface, or more generally, the gripping surface may be convexly shaped in vertical direction. The gripping surface may for example be formed as a partly cylindrical surface, wherein the longitudinal axis of the cylindrical surface extends in horizontal direction when the substrate W is held in a horizontal plane. The advantage of the convex shape of the edge fingers is that the gripping surface may effectively deal with local angles of warped substrates and various shapes and materials at the edge of the substrate W. Mechanically pre-loaded springs may be provided for safety in case the edge gripper actuators do not function properly. Alternatively or additionally, to increase substrate safety a safety rim (not shown) may be provided at the bottom end of the gripping surface to catch a substrate W in case of malfunctioning of the substrate holder SH.

The substrate holder SH may comprise one or more edge detection devices EDD configured to detect whether the one or more edge grippers EGR contact the circumferential edge of the substrate W to be held. The edge detection devices EDD may be used to efficiently grip the substrate W by moving the edge fingers individually in gripping direction GRD towards the edge of the substrate W. The movement of the one or more edge fingers may be stopped when it is detected by the respective edge detection device EDD that the respective edge finger contacts the circumferential edge of the substrate W. This has the advantage that each edge finger can be quickly moved to the actual position of the edge of the substrate W instead of an expected position of the edge of the substrate W. When one of the edge fingers has reached the edge, the other edge fingers may continue to move in gripping direction GRD towards the edge until it is detected by the associated edge detection device EDD that a respective edge finger has reached the edge of the substrate W.

In the embodiment shown in Fig. 5 the edge detection devices EDD are schematically shown as external sensors. In practice, the edge detection of the edge detection device EDD may for example be based on velocity change of the respective edge finger. When the edge finger contacts the substrate W, the edge finger will rapidly decelerate to zero velocity. An encoder may be provided to measure the velocity with which the edge finger is moved in radial direction. If the measured encoder velocity falls below a certain minimum velocity threshold level, the edge detection device EDD may determine that the edge is reached and movement in radial direction should be stopped. In another embodiment, the edge detection of the edge detection device EDD may be based on a positioning error change. In a controller (e.g. the controller CON of Figs. 2 and 3), a pre-defined buffer may be filled with the position of the edge finger continuously to store the last defined number of samples. If the error in positioning of the edge finger becomes larger than a predetermined threshold error level, it is possible to determine that the edge finger has reached the edge of the substrate W and movement in radial direction should be stopped. In yet another embodiment, the edge detection of the edge detection device EDD may be based on feedback output change. When the edge finger is approaching the substrate W with a constant velocity, the output of the feedback is expected to be relatively small. However, if a contact between edge finger and edge of the substrate W occurs, due to the positioning error, the feedback controller CON starts to increase the actuation force. Thus, when the actuation force exceeds an actuation force threshold, the edge detection device EDD may determine that the edge is reached and movement in radial direction should be stopped.

The first two edge fingers that contact the edge of the substrate W may be used for positioning, since two points may determine the substrate in-plane position. The further edge fingers, in this example two further edge fingers, may be used to preload the substrate W to the edge fingers and to provide friction force in vertical z-direction. In an embodiment, a controller (e.g. the controller CON of Figs. 2 and 3) may be configured to change from position control to velocity control, when the edge detection device EDD has determined that the edge of the substrate W is reached to apply the gripping force without undesired oscillation. The edge gripper actuators allow repositioning of the substrate W in x-direction and/or y-direction when the substrate W is held by the edge grippers EGR. This may for example be advantageous when during the gripping of the substrate W it is determined by the controller that the substrate W is offset with respect to the substrate holding position of the substrate holder SH. This may for example be determined on the basis of the timing and/or locations of the edge fingers where the edge detections devices EDD detect that the edge fingers contact the edge of the substrate W. By controlled movement of the edge grippers EGR by the edge gripper actuators, the actual position of the substrate W with respect to the substrate holding position, i.e. the desired position, may be corrected.

The edge grippers EGR are further designed to allow movement of the edge fingers in a tangential direction TAD with respect to the central axis CEN of the substrate holding position. One of the edge grippers EGR may comprise a tangential actuator (not shown). The tangential actuator may, for example, comprise a piezo actuator. The other edge grippers EGR may allow movement of the edge finger in a tangential direction TAD, but may not comprise an actuator to actively control this movement in tangential direction. In alternative embodiments, two or more, or all edge grippers EGR may comprise a tangential actuator to control movement of the respective edge fingers in a tangential direction TAD. By actuation of the tangential actuator, the edge of the substrate W can be displaced in a tangential direction TAD. Since the other edge grippers EGR allow such movement in the tangential direction TAD, such actuated movement of the substrate W in tangential direction will result in rotation of the substrate W in the substrate holder SH about a central axis CEN of the substrate W, e.g. in Rz-direction, over a limited angle of for example +/- 50 mrad, for instance +/- 10 mrad. By subsequent gripping and releasing of the edge fingers on the edge of the substrate W and small rotations of the substrate W in Rz-direction, the substrate W may be rotated over larger angles. The combination of edge gripper actuators and tangential actuator allow the substrate W to be repositioned in x-direction, y-direction and Rz-direction. This makes correction of the position of the substrate W in any direction in the x-y plane possible. As shown in Fig. 5, it is possible for an embodiment to comprise both movable contactless clamping devices CP that are actively movable in z-direction and edge grippers EGR that are actively movable in radial and/or tangential directions.

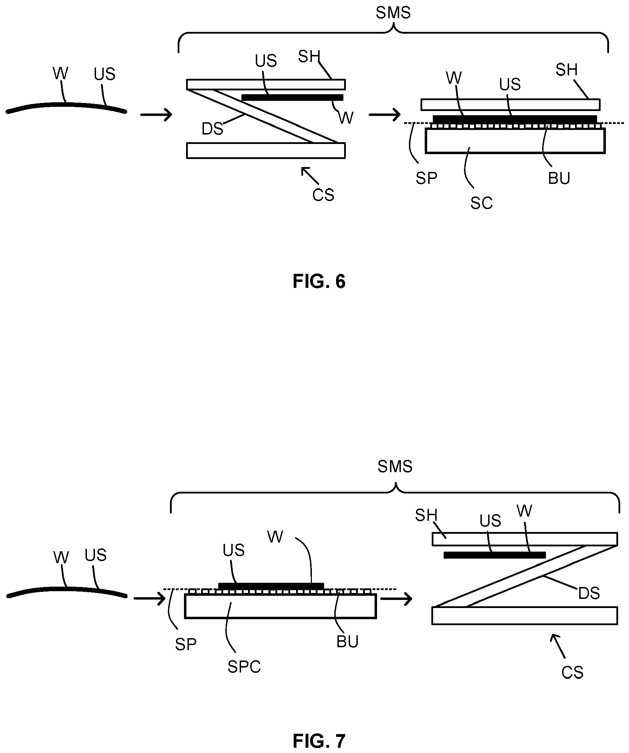

Fig. 6 schematically depicts a substrate manipulation system SMS comprising a substrate clamp SC according to an embodiment of the present disclosure. The substrate manipulation system SMS comprises the carrier system CS of Fig. 1. The carrier system CS comprises a substrate holder SH and a displacement system DS, for example a robotic system such as a robotic arm or a linear movement system. The substrate holder SH may be the substrate holder of any of Figs. 2-5. The substrate clamp SC comprises a support plane SP configured to support the substrate W. In the example of Fig. 6, the support plane SP is defined by a plurality of burls BU (e.g. between about 5000 and about 10000 burls) configured to support the substrate W from an underside thereof. The carrier system CS is configured to contactlessly collect the substrate W, e.g. from a substrate storage (not shown), and load the substrate W onto the substrate clamp SC. The substrate W is warped in a stress-free state before the substrate holder SH contactlessly grabs the substrate W. In the example of Fig. 6, the substrate W is warped in an umbrella shape. The substrate W may be warped in other shapes. The substrate holder SH is configured to apply the electrostatic attraction generated by the surface clamping device and the repulsive force generated by the fluid flow device to the substrate W to contactlessly deform the substrate W such that the upper surface US of the substrate W substantially matches the support plane SP. The support plane SP may be substantially flat, in which case, the substrate holder SH may deform the substrate W from a warped shape to a substantially flat shape before loading the substrate W onto the substrate clamp SC. The substrate clamp SC may then activate electrostatic clamps (not shown) to hold the substrate W on the burls BU of the substrate clamp SC. The substrate holder SH may deactivate the surface clamping device and the fluid flow device to release the substrate W and thereby load the substrate W onto the substrate clamp SC.

Substantially matching the upper surface US of the substrate W to the support plane SP of the substrate clamp SC before loading the substrate W onto the substrate clamp SC advantageously reduces or avoids frictional movement of the substrate W when the substrate W is clamped by the substrate clamp SC. This in turn advantageously reduces wear on the substrate clamp SC, thereby increasing an operational lifetime of the substrate clamp SC compared to known substrate manipulation systems. Substantially matching the upper surface US of the substrate W to the support plane SP of the substrate clamp SC also advantageously reduces manufacturing errors such as, in the example of lithography, focus errors and/or overlay errors. For example, on-product-overlay may be improved by more than 1 nm when the substrate manipulation system SMS is used as part of a lithographic apparatus (such as the lithographic apparatus LA of Fig. 1). The substrate clamp SC may be the substrate table WT of Fig. 1.

Fig. 7 schematically depicts a substrate manipulation system SMS comprising a substrate pre-clamp SPC according to an embodiment of the present disclosure. The substrate manipulation system SMS comprises the carrier system CS of Fig. 1. The carrier system CS comprises a substrate holder SH and a displacement system DS, for example a robotic system such as a robotic arm or a linear movement system. The substrate holder SH may be the substrate holder of any of Figs. 2-5. The substrate pre-clamp SPC comprises a support plane SP configured to support the substrate W. In the example of Fig. 7, the support plane SP is defined by a plurality of burls BU configured to support the substrate W from an underside thereof. The carrier system CS is configured to contactlessly collect the substrate W from the substrate pre-clamp SPC and move the substrate W to another location (e.g. the substrate table WT of Fig. 1). The substrate pre-clamp SPC is configured to clamp the substrate W. In clamping the substrate W, the substrate pre-clamp SPC deforms the substrate W such that the upper surface US of the substrate W matches the support plane SP of the substrate pre-clamp SPC. The substrate pre-clamp SPC may comprise one or more electrostatic clamps configured to clamp the substrate W onto burls BU. In the example of Fig. 7, the support plane SP of the substrate pre-clamp SPC is substantially flat, so the substrate pre-clamp SPC deforms the substrate W such that the upper surface US of the substrate is also substantially flat. The substrate W is warped in a stress-free state before the substrate pre-clamp SPC clamps, and thereby deforms, the substrate W into a substantially flat shape. In the example of Fig. 7, the substrate W is warped in an umbrella shape. The shape of the substrate W whilst the substrate W is clamped by the substrate pre-clamp SPC may be used as a reference shape that is to be maintained by the substrate holder SH. The substrate holder SH is configured to apply the electrostatic attraction and the repulsive force to maintain the deformed shape of the substrate W once the substrate W has been released from the substrate pre-clamp SPC. In the example of Fig. 7, the substrate holder SH is configured to apply the electrostatic attraction generated by the surface clamping device and the repulsive force generated by the fluid flow device to the substrate W such that the upper surface US of the substrate W remains substantially flat after rather than returning to the warped umbrella shape. The carrier system CS may then move the substrate W to another location. For example, the carrier system CS may load the substrate W onto the substrate table WT of Fig. 1. The substrate pre-clamp SPC may be a vacuum pre-alignment clamp that forms part of a lithographic apparatus (such as the lithographic apparatus LA of Fig. 1). The vacuum pre-alignment clamp may comprise pressures of about 10 Torr or less. The vacuum pre-alignment clamp may comprise pressures of about 1 Torr or less. The substrate W may undergo one or more processes when clamped by the substrate pre-clamp SPC such as, for example, thermal conditioning, alignment measurements, etc.

Maintaining the pre-deformed shape of the substrate W advantageously reduces frictional movement of the substrate W when the substrate W is loaded onto a substrate support, such as the substrate table WT of Fig. 1. This in turn advantageously reduces wear on the substrate manipulation system SMS and the substrate table WT. Maintaining the pre-deformed shape of the substrate W advantageously reduces manufacturing errors such as, in the example of lithography, focus errors and/or overlay errors (e.g. on-product-overlay is improved by more than 1 nm).

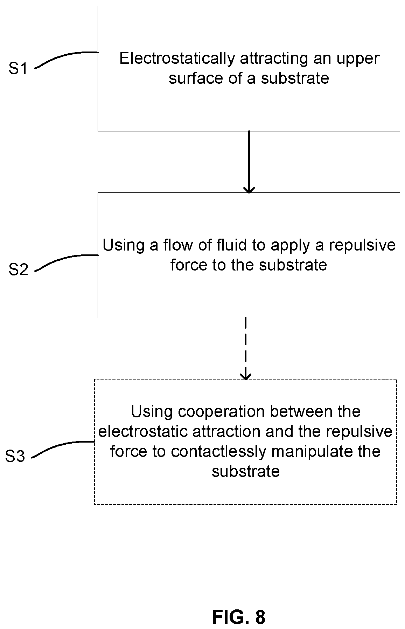

Fig. 8 shows a flowchart of a method of holding a substrate according to an embodiment of the present disclosure. A first step S1 of the method comprises electrostatically attracting an upper surface of the substrate. A second step S2 of the method comprises using a flow of fluid to apply a repulsive force to the substrate. The method may comprise an optional third step S3 of using cooperation between the electrostatic attraction and the repulsive force to contactlessly manipulate the substrate as previously described in relation to the substrate holder of the present disclosure. The method may further comprise adjusting at least one of the electrostatic attraction and the repulsive force to deform the substrate into a predetermined shape, such as, for example, a substantially flat upper surface. The method may further comprise using a substrate pre-clamp to deform the substrate such that the upper surface of the substrate substantially matches a support plane of the substrate pre-clamp, e.g. as previously described in relation to Fig. 6. The method may further comprise applying the electrostatic attraction and the repulsive force to maintain the deformed shape of the substrate, e.g. as previously described in relation to Fig. 7. The method may further comprise using the fluid flow to control a temperature of the substrate as previously described. The method may be used as part of a semiconductor manufacturing process such as, for example, a lithographic process (e.g. projecting a patterned beam of radiation onto the upper surface of the substrate) and/or a material deposition process (e.g. thin film deposition on the substrate).

Hereinabove, different embodiments of substrate holders SH have been described that can be used in a lithographic apparatus LA as shown in Fig. 1. The substrate holder SH may be used to hold and otherwise manipulate the reticle MA (e.g. to load and unload the reticle MA from the support structure MT). The substrate holder SH may also be used as part of a carrier system CS to hold substrates in other apparatus used in the lithographic production process, such as substrate measurement or substrate inspection devices. The substrate holder SH is in particular beneficial when a controlled positioning or controlled shape of the substrate W is desired. The substrate holder SH is not limited to lithographic apparatus and may be used in other semiconductor processing apparatus such as, for example, vacuum clamps, electron beam lithographic apparatus, chemical vapor deposition systems, ion implantation apparatus etc.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions (e.g. pressures of about 10 Torr or less) or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world. For example, the controller CON of Figs. 2-3 may comprise a computer readable medium and/or a computer apparatus comprising a memory storing processor readable instructions and a processor arranged to read and execute instructions stored in said memory. Said computer readable medium and/or instructions may comprise a computer program comprising computer readable instructions configured to cause a computer (e.g. the controller CON) to carry out a method according to the present disclosure (e.g. the method of Fig. 8 and its associated description).

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### Clauses

1. A substrate holder for holding a substrate, comprising: a frame; a surface clamping device arranged on the frame configured to electrostatically attract the substrate at an upper surface thereof; and, a fluid flow device arranged on the frame configured to apply a repulsive force to the substrate.
2. The substrate holder of clause 1, wherein the surface clamping device and the fluid flow device are configured to cooperate to provide contactless manipulation of the substrate.
3. The substrate holder of clause 1 or clause 2, wherein the surface clamping device comprises a plurality of electrostatic clamps configured to electrostatically attract the upper surface of the substrate.
4. The substrate holder of any preceding clause, wherein the fluid flow device comprises a plurality of conduits configured to convey a flow of fluid that applies the repulsive force to the substrate.
5. The substrate holder of clause 3 and clause 4, wherein the plurality of electrostatic clamps and the plurality of conduits cooperate to form a plurality of contactless clamping devices.
6. The substrate holder of clause 5, wherein at least one of the plurality of electrostatic clamps comprises an aperture and at least one of the plurality of conduits is configured to provide a flow of a fluid through the aperture.
7. The substrate holder of any preceding clause, comprising an actuation system configured to move the surface clamping device and the fluid flow device with respect to each other.
8. The substrate holder of any preceding clause, comprising a controller configured to adjust at least one of the electrostatic attraction and the repulsive force to deform the substrate into a predetermined shape.
9. The substrate holder of any preceding clause, wherein the surface clamping device is configured to detect a position and/or a shape of the substrate.
10. The substrate holder of clause 9, wherein the controller is configured to use information detected by the surface clamping device to adjust at least one of the electrostatic attraction and the repulsive force to control a position and/or a shape of the substrate.
11. The substrate holder of any preceding clause, wherein the flow of fluid is configured to control a temperature of the surface clamping device, and/or wherein the flow of fluid is configured to control a temperature of the substrate.
12. The substrate holder of any preceding clause, comprising an edge gripper system configured to hold the substrate at an edge thereof.
13. A substrate manipulation system comprising: the substrate holder of any preceding clause; and, a substrate clamp comprising a support plane configured to support the substrate, wherein the substrate holder is configured to apply the electrostatic attraction and the repulsive force such that the upper surface of the substrate substantially matches the support plane.
14. A substrate manipulation system comprising: the substrate holder of any of clauses 1 to 12; and, a substrate pre-clamp configured to deform the substrate into a deformed shape, wherein the substrate holder is configured to apply the electrostatic attraction and the repulsive force to maintain the deformed shape of the substrate.
15. A semiconductor processing apparatus comprising the substrate holder of any of clauses 1 to 12, wherein the substrate holder is arranged to operate in a vacuum or near-vacuum environment.
16. The semiconductor processing apparatus of clause 15, wherein the semiconductor processing apparatus is a lithographic apparatus configured to expose the substrate to patterned radiation, or wherein the semiconductor processing apparatus is a chemical vapor deposition apparatus configured to deposit material on the substrate.
17. A method of holding a substrate comprising: electrostatically attracting an upper surface of the substrate; and, using a flow of fluid to apply a repulsive force to the substrate.
18. The method of clause 17, comprising using cooperation between the electrostatic attraction and the repulsive force to contactlessly manipulate the substrate.
19. The method of clause 18, comprising adjusting at least one of the electrostatic attraction and the repulsive force to deform the substrate into a predetermined shape.
20. The method of clause 18, comprising: using a substrate pre-clamp to deform the substrate such that the upper surface of the substrate substantially matches a support plane of the substrate pre-clamp; and, applying the electrostatic attraction and the repulsive force to maintain the deformed shape of the substrate.
21. The method of any of clauses 17 to 20, comprising using the fluid flow to control a temperature of the substrate.
22. A method of projecting a patterned beam of radiation onto a substrate comprising the method of any of clauses 17 to 21, or a method of depositing material on a substrate comprising the method of any of clauses 17 to 21.
23. A computer program comprising computer readable instructions configured to cause a computer to carry out a method according to any of clauses 17 to 22.
24. A computer readable medium carrying a computer program according to clause 23.
25. A computer apparatus comprising: a memory storing processor readable instructions; and a processor arranged to read and execute instructions stored in said memory; wherein said processor readable instructions comprise instructions arranged to control the computer to carry out a method according to any of clauses 17 to 22.

## Claims

1. A substrate holder for holding a substrate, comprising:
a frame;
a surface clamping device arranged on the frame configured to electrostatically attract the substrate at an upper surface thereof; and,
a fluid flow device arranged on the frame configured to apply a repulsive force to the substrate.

2. The substrate holder of claim 1, wherein the surface clamping device and the fluid flow device are configured to cooperate to provide contactless manipulation of the substrate.

3. The substrate holder of claim 1 or claim 2, wherein the surface clamping device comprises a plurality of electrostatic clamps configured to electrostatically attract the upper surface of the substrate.

4. The substrate holder of any preceding claim, wherein the fluid flow device comprises a plurality of conduits configured to convey a flow of fluid that applies the repulsive force to the substrate.

5. The substrate holder of claim 3 and claim 4, wherein the plurality of electrostatic clamps and the plurality of conduits cooperate to form a plurality of contactless clamping devices.

6. The substrate holder of claim 5, wherein at least one of the plurality of electrostatic clamps comprises an aperture and at least one of the plurality of conduits is configured to provide a flow of a fluid through the aperture.

7. The substrate holder of any preceding claim, comprising an actuation system configured to move the surface clamping device and the fluid flow device with respect to each other.

8. The substrate holder of any preceding claim, comprising a controller configured to adjust at least one of the electrostatic attraction and the repulsive force to deform the substrate into a predetermined shape.

9. The substrate holder of any preceding claim, wherein the surface clamping device is configured to detect a position and/or a shape of the substrate.

10. The substrate holder of any preceding claim, wherein the flow of fluid is configured to control a temperature of the surface clamping device,
and/or wherein the flow of fluid is configured to control a temperature of the substrate.

11. The substrate holder of any preceding claim, comprising an edge gripper system configured to hold the substrate at an edge thereof.

12. A substrate manipulation system comprising:
the substrate holder of any preceding claim; and,
a substrate clamp comprising a support plane configured to support the substrate, wherein the substrate holder is configured to apply the electrostatic attraction and the repulsive force such that the upper surface of the substrate substantially matches the support plane.

13. A semiconductor processing apparatus comprising the substrate holder of any of claims 1 to 11, wherein the substrate holder is arranged to operate in a vacuum or near-vacuum environment.

14. The semiconductor processing apparatus of claim 13, wherein the semiconductor processing apparatus is a lithographic apparatus configured to expose the substrate to patterned radiation,
or wherein the semiconductor processing apparatus is a chemical vapor deposition apparatus configured to deposit material on the substrate.

15. A method of holding a substrate comprising:
electrostatically attracting an upper surface of the substrate; and,
using a flow of fluid to apply a repulsive force to the substrate.
